# EUROPÄISCHE PATENTSCHRIFT

(11) **EP 3 816 533 B1**
(45) Veröffentlichungstag und Bekanntmachung des Hinweises auf die Patenterteilung: **11.12.2024**
(21) Anmeldenummer: 19206189.3
(22) Anmeldetag: 30.10.2019
(51) Int. Cl.: F24H 1/10, F24H 9/02, H05K 5/02, H05K 7/14

(54) **DURCHLAUFERHITZER MIT EINEM GEHÄUSE**
CONTINUOUS FLOW HEATER WITH A HOUSING
CHAUFFE-EAU INSTANTANÉ DOTÉ D'UN BOÎTIER

(43) Veröffentlichungstag der Anmeldung: 05.05.2021
(73) Patentinhaber: Gerdes Holding GmbH & Co. KG, 21337 Lüneburg (DE)
(72) Erfinder: Koch, Christian, 21403 Wendisch Evern (DE)
(74) Vertreter: Stork Bamberger Patentanwälte PartmbB

(56) Entgegenhaltungen:
- WO-A1-2018/129826
- CN-U- 203 289 735
- CN-Y- 201 238 417
- DE-A1- 102010 043 933
- DE-A1- 102013 208 984
- JP-U- H0 736 491
- JP-U- S60 108 077
- US-A1- 2013 329 381

## Beschreibung

Die vorliegende Erfindung betrifft einen Durchlauferhitzer mit einem Gehäuse.

Bekannte elektrische Durchlauferhitzer der genannten Art weisen regelmäßig ein Gehäuse zum Befestigen der in dem Durchlauferhitzer befindlichen Komponenten, wie beispielsweise einer Kanalanordnung mit einem oder mehreren Heizkanälen, der Steuerungs- und Leistungselektronik und ggf. der Anzeige- und Bedienelemente, auf. Ferner dient das Gehäuse zur Montage des Durchlauferhitzers, beispielsweise zur Wandmontage, und hat zudem häufig die Funktion bestimmte Bereiche im Innenraum des Durchlauferhitzers voneinander räumlich zu trennen.

Das Gehäuse derartiger Durchlauferhitzer ist dabei zum Beispiel als Kunststoffspritzteil gefertigt, das ausreichende Festigkeit und elektrische Isolationseigenschaften aufweist. Üblicherweise weist das Gehäuse des gattungsgemäßen Durchlauferhitzers mindestens ein Gehäuseunterteil sowie eine Gehäusehaube auf, wobei einzelne Teile aus separaten Kunststoffspritzteilen gefertigt sein können, die in nachträglichen Bearbeitungs- und/oder Montageschritten zu einem vollständigen Gehäuse zusammengefügt werden. In der Regel werden an den Gehäuseunterteilen sämtliche hydraulischen und die Leistungselektronik umfassenden Komponenten angeordnet, während die Gehäusehaube der elektrischen Isolation des Geräteinneren, als Schutz vor Spritz- und Strahlwasser, zur Anordnung und/oder zum Schutz von Bedien- und Anzeigeeinrichtungen dient. Über die Lebensdauer von Durchlauferhitzern werden diese Gehäuse in der Regel regelmäßig geöffnet, um beispielsweise Wartungs- und/oder Reparaturarbeiten an dem Durchlauferhitzer bzw. an den darin angebrachten Komponenten durchzuführen.

Durchlauferhitzer mit einem Gehäuse sind hinlänglich bekannt, beispielsweise geht aus dem Dokument DE 29721815 U1 ein Gehäuse für einen elektrischen Durchlauferhitzer hervor. Der Durchlauferhitzer weist einen besonders angeformten Bestandteil der Abdeckhaube und des Grundträgers auf, wodurch das Gehäuse ohne zusätzliche Befestigungshilfsmittel auskommt.

Zudem geht aus der EP 2 641 030 B1 ein Gehäuse für einen elektrischen Durchlauferhitzer mit einem Montagerahmen zur Aufnahme zumindest eines Heizblocks und einer geräteinternen Verrohrung zur Zuführung von Kaltwasser zum Heizblock und zur Entnahme von Warmwasser aus dem Heizblock hervor.

Aus der CN201238417 Y ist ein elektronisches Bauteil, insbesondere eine Leiterplattenmontagestruktur, bekannt, die einen Träger und eine Leiterplatte umfasst. Die Halterung ist mit einem Haltetank versehen, der zum Halten der Leiterplatte verwendet wird und ein elastischer Haken ist an der Seitenwand des Haltetanks angeordnet.

Die WO2018129826 A1 zeigt ein Vorrichtung zum Befestigen einer Leiterplatte mit einem vorderen Begrenzungsteil, einem hinteren Begrenzungsteil, einem elastischen Schnappverschluss und einem Platzierungsschlitz, wobei, wenn die Leiterplatte in dem Platzierungsschlitz platziert wird, eine Kerbe der Leiterplatte durch das vordere Begrenzungsteil verläuft, so dass die Leiterplatte gegen den elastischen Schnappverschluss drückt und der elastische Schnappverschluss verformt wird; und wenn sich die gedruckte Leiterplatte von dem elastischen Schnappverschluss wegbewegt, bis der elastische Schnappverschluss von der Verformung zurückgesetzt ist, drücken das vordere Begrenzungsteil und das hintere Begrenzungsteil gegen die gedruckte Leiterplatte, und der elastische Schnappverschluss drückt gegen die gedruckte Leiterplatte. Bei der Konstruktion der Gehäuse für Durchlauferhitzer sind grundsätzlich eine Vielzahl technischer Anforderungen zu berücksichtigen, beispielsweise die Platzierung und Anordnung des Heizblocks, die Lage hydraulischer und elektrischer Leitungen, Isolations- und EMV-Gesichtspunkte sowie die Möglichkeit der Montage des Durchlauferhitzers in unterschiedlichen Einbausituationen am Einsatzort.

Moderne Durchlauferhitzer weisen zunehmend eine Vielzahl steuerelektronischer Komponenten auf, die neben Schaltungen für komplexe Steuerungsaufgaben u. a. auch elektronische Schaltungen zur Bedienung umfassen, wie z. B. zur Integration von Touch-Displays, Sprachsteuerung oder von Schnittstellen zur drahtlosen Kommunikation. Zur Umsetzung der genannten Funktionen sind in der Regel eine Vielzahl elektronischer Bauteile erforderlich. Regelmäßig werden solche Schaltungen als gedruckte Schaltungen ausgeführt, bei der die Bauteile auf Leiterplatten angeordnet sind. Trotz des bereits erreichten Miniaturisierungsgrades, beispielsweise durch die Verwendung von SMD-Bauteilen, werden häufig zahlreiche elektronische Bauelemente benötigt, bei denen eine Miniaturisierung der Bauform nicht oder nur eingeschränkt möglich ist. Insbesondere Bauteile für den Drehstrom- oder Netzspannungsbetrieb sind aufgrund der erforderlichen Isolationsabstände von vergleichsweise großer Bauform. Auch Kondensatoren, vor allem Elektrolyt-Kondensatoren, haben einen erhöhten Platzbedarf. Ebenso weisen induktive Bauelemente, wie Spulen, Übertrager oder Transformatoren zum Teil entsprechend große Bauformen auf.

Aus Gründen einer möglichst einfachen und kosteneffizienten Montage werden die Leiterplatten derartiger gedruckter Schaltungen häufig am Gehäuse mittels Schnappelementen lösbar angeordnet.

Nachteilig ist, dass die bekannten Durchlauferhitzer keine Befestigung von Leiterplatten mit Bauelementen entsprechend großer Bauform ermöglichen, insbesondere keine einfache und zuverlässige Befestigung der Leiterplatte am Gerätegehäuse ohne Verschraubung. Insbesondere Leiterplatten mit Bauteilen großer Bauformen, die über entsprechend große geometrische Abmessungen sowie ein vergleichsweises hohes Eigengewicht verfügen, können mit den bekannten Schnappelementen nicht ausreichend mechanisch gesichert werden. Zudem müssen die Schnappelemente bei einer häufig zweckdienlichen Überkopfmontage der Leiterplatten, bei der die Bestückungsseite zum Gehäuseboden zeigend angeordnet ist, aufgrund großer Bauhöhen der genannten Bauelemente entsprechend lang ausgeführt sein, um die Leiterplatte vom Gehäuseboden beabstandet aufzuständern. Mit zunehmender Baulänge der Schnappelemente nimmt deren Gesamtsteifigkeit ab, so dass die gewünschte zuverlässige mechanische Sicherung der Leiterplatte nicht mehr gegeben ist.

Während der Lebensdauer eines Durchlauferhitzers kann es aus Gründen der Produktaufwertung oder beispielsweise im Zusammenhang mit defekten Komponenten, vor allem nach einer Überspannung im Stromnetz, regelmäßig notwendig sein, einzelne Komponenten auszutauschen, zu warten oder zu erneuern. Zu Wartungs- oder Reparaturarbeiten ist es in der Regel erforderlich, die Leiterplatten mit den elektronischen Bauteilen auszubauen oder gegen Ersatz-Platinen auszutauschen. Gerade bei aufgeständerten Leiterplatten, die am Ende von Schnappelementen vergleichsweise langer Bauform angeordnet sind, kann es zu Beschädigungen der Schnappelemente kommen.

Es ist daher Aufgabe der vorliegenden Erfindung, einen Durchlauferhitzer mit einem Gehäuse vorzuschlagen, der eine möglichst einfache Montage und Demontage der Leiterplatten bei gleichzeitiger sicherer mechanischer Befestigung derselben am Gehäuse erlaubt. Insbesondere ist es Aufgabe der Erfindung, die genannten Anordnung und Sicherung der Leiterplatten auch bei aufgeständerten Leiterplatten sicherzustellen.

Die Aufgabe wird durch den eingangs genannten Durchlauferhitzer gelöst, umfassend ein Gehäuse mit einem Gehäuseunterteil, wobei das Gehäuseunterteil einen Gehäuseboden umfasst, und wobei der Gehäuseboden mindestens zwei zumindest im Wesentlichen senkrecht zum Gehäuseboden verlaufend angeordnete Rastelemente mit einem Rastbereich und einem Arretierbereich umfasst, wobei die Rastelemente zum lösbaren Anordnen einer eine Lötseite und eine Bestückungsseite umfassenden Leiterplatte ausgebildet sind, indem die Leiterplatte zumindest im Rastbereich der Rastelemente in einer Rastposition anordenbar ist, wobei der Durchlauferhitzer weiter eine Leiterplattenabdeckung umfasst, wobei die Leiterplattenabdeckung die Lötseite der Leiterplatte zumindest bereichsweise abdeckt und die Rastelemente mit der in der Rastposition befindlichen Leiterplatte in einem Arretierzustand arretiert, indem die Leiterplattenabdeckung ausgebildet ist, die Rastelemente im Arretierbereich unter Bildung einer Arretieranlage zu umgreifen.

Der erfindungsgemäße Durchlauferhitzer weist den Vorteil auf, dass stets eine mechanisch sichere Anordnung der Leiterplatte in dem Gehäuse des Durchlauferhitzers bei gleichzeitig möglichst einfacher Handhabung bei Montage und Demontage derselben gewährleistet ist. Aufgrund der Anordnung der Leiterplatte in der Rastposition und der Arretierung der Leiterplatte in einem Arretierzustand mittels der Leiterplattenabdeckung ist die Leiterplatte in den Rastelementen sicher verrastet und zudem durch die Leiterplattenabdeckung gegen ein unerwünschtes Lösen gesichert und zusätzlich arretiert. Durch diese mechanische Doppelsicherung ist die Leiterplatte nicht nur über die Rastelemente an dem Gehäuse angeordnet, sondern die Rastelemente sind mittels der Leiterplattenabdeckung zusätzlich mechanisch gesichert. Zudem wirkt die Leiterplattenabdeckung als Aussteifungselement, so dass die Rastelemente mit der Leiterplattenabdeckung im verbundenen Zustand eine Einheit deutlich erhöhter mechanischer Steifigkeit bilden.

"Umgreifen" im Sinne der Erfindung stellt das flächige Anliegen der Leiterplattenabdeckung an den Arretierbereich der Rastelemente dar; alternativ ist unter dem Begriff "Umgreifen" in diesem Zusammenhang auch ein Touchieren des Arretierbereichs der Rastelemente durch die Leiterplattenabdeckung zu verstehen, also ein Berühren miteinander bzw. ein Anliegen der jeweiligen Elemente aneinander.

Ein weiterer Vorteil besteht darin, dass etwaige Krafteinwirkungen auf die Leiterplatte durch die Rastelemente über die Leiterplattenabdeckung aufgenommen werden, so dass es allenfalls nur zu einer geringen Krafteinleitung in die Leiterplatte über die Rastelemente kommen kann. Auf diese Weise werden mechanische Belastung des Leiterplattenträgermaterials weitestgehend vermieden und es wird unerwünschten Leiterbahnbrüchen oder Kontaktunterbrechungen zu elektronischen Bauteilen durch "kalte Lötstellen" entgegengewirkt. Aufgrund der sicheren mechanischen Anordnung der Leiterplatte wird zudem mechanischem Schwingen der Leiterplatte relativ zu dem Gehäuse entgegengewirkt. Auf diese Weise ist es insbesondere möglich, Leiterplatten sicher anzuordnen, die mit ihrer Bestückungsseite zum Gehäuseboden gerichtet angeordnet sind und auf deren Bestückungsseite elektronische Bauteile vergleichsweise großer Bauhöhe verbaut sind. Die doppelte Sicherung der Leiterplatte mittels der vorgenannten Rastelemente und der vorgenannten Leiterplattenabdeckung ermöglicht eine zuverlässige und wieder lösbare Befestigung der Leiterplatten an dem Gehäuse. Ein weiterer Vorteil der Verrastung der Leiterplatte durch die gegenseitige Verriegelung mittels der Rastelemente und der Leiterplattenabdeckung besteht darin, dass die Materialstärke der Elemente deutlich filigraner ausgestaltet sein kann, weil weniger Kräfte auf die Elemente wirken, wodurch wiederum der Materialeinsatz reduziert wird, was insbesondere in einem geringeren Kunststoffeinsatz resultiert.

Lötseite und Bestückungsseite im Sinne der Erfindung sind die beiden flächigen Seiten der Leiterplatte. Dabei sind auf der Lötseite überwiegend die Lötstellen zum elektrischen Verbinden der elektronischen Bauteile mit den Leiterbahnen der Leiterplatte angeordnet, jedenfalls bei Bauteilen, bei denen die Anschlussdrähte durch Bohrlöcher der Leiterplatte gesteckt sind, wohingegen auf der Bestückungsseite überwiegend die elektronischen Bauteile selbst angeordnet sind. Die Bestückungsseite weist vor allem diejenigen elektronischen Bauteile mit einer entsprechend großen Bauhöhe und daher größerem Platzbedarf auf. Es findet bei der Leiterplatte des erfindungsgemäßen Durchlauferhitzers jedoch keine strikte begriffliche Trennung zwischen Lötseite und Bestückungsseite statt; das heißt, dass durchaus elektronische Bauteile auf der Lötseite angeordnet sein können bzw. verlötete Kontakte auf der Bestückungsseite, insbesondere können sowohl auf der Löt- als auch auf der Bestückungsseite oberflächenmontierte elektronische Bauelemente, sogenannte SMD-Bauteile, angeordnet sein.

Die Rastelemente sind vorzugsweise in der Höhe derart ausgebildet, dass die mit den elektronischen Bauteilen bestückten Leiterplatten in den Rastbereich einrastbar sind und ein ausreichender Abstand zwischen den elektronischen Bauteilen und dem Gehäuseboden besteht, so dass zwischen der Leiterplatte und dem Gehäuseboden ein Aufnahmeraum entsteht. Der genannte Abstand zwischen der Leiterplatte und dem Gehäuseboden gewährleistet stets eine ausreichende Kühlung sich erwärmender Komponenten.

Die Rastelemente sind derart ausgebildet, dass ein Verrasten der Leiterplatte im Zuge des Anordnens erfolgt. Dazu kann die Leiterplatte bei der Montage vorzugsweise nahezu kraftfrei über die Rasthaken der Rastelemente geschoben und anschließend in dem Rastbereich angeordnet werden. Beim Anordnen der Leiterplatte an den Rastelementen im Rastbereich wird die Leiterplatte in einer Rastposition gehalten und so mechanisch fixiert und gegen unerwünschtes Lösen gesichert. Die mindestens zwei Rastelemente sind in ihrer Bauhöhe grundsätzlich variabel wählbar, wobei die Bauhöhe insbesondere von der eingesetzten Leiterplatte sowie der maximalen Bauhöhe der elektronischen Bauteile abhängig ist. Eine große Bauteilhöhe erfordert dementsprechend lange Rastelemente, um ein Anordnen der Leiterplatte zwischen den Rastelementen zu ermöglichen. Die Höhe der Rastelemente liegt vorzugsweise im Bereich zwischen 3 cm und 15 cm.

Bevorzugt können die Rastelemente je nach Ausgestaltung des Gehäuses des Durchlauferhitzers im Bedarfsfall in mindestens einer Gehäusewand des Gehäuseunterteils integriert sein. Die Rastelemente sind also nicht darauf beschränkt, als individuelles Element in dem Durchlauferhitzer angeordnet zu sein, sondern können auch als Bestandteil eines größeren Gehäuseelements ausgebildet sein.

Der Arretierbereich der Rastelemente ist vorzugweise derart gestaltet, dass die Leiterplattenabdeckung die Rastelemente unter Bildung einer Arretieranlage umgreift. Das bedeutet, dass zumindest ein Teil der Leiterplattenabdeckung eine flächige Gegenlage aufweist, die ausgebildet ist, in dem Arretierbereich der Rastelemente in Kontaktanlage zu kommen. Vorzugsweise sind der Arretierbereich sowie die Leiterplattenabdeckung derart korrespondierend zueinander ausgebildet, dass die Gegenlage die Rastelemente umgreift. Unter Kontaktanlage ist jegliches Anliegen der Leiterplattenabdeckung an dem Arretierbereich zu verstehen, das zur Bildung einer mechanischen Verbindung zwischen den Rastelementen und der Leiterplattenabdeckung zur ergänzenden Fixierung beider führt.

In einer weiteren vorteilhaften Ausgestaltung der Erfindung umfasst der Gehäuseboden mindestens drei voneinander beabstandete Rastelemente mit jeweils einem der Rastbereiche und einem der Arretierbereiche. Auf diese Weise kann auf spezielle Eigenschaften der Leiterplatte Einfluss genommen werden, zum Beispiel falls die Leiterplatte große Abmessungen aufweist oder elektronische Bauteile großer Masse beinhaltet. In weiteren vorteilhaften Ausführungen kann der Gehäuseboden auch mehr als drei Rastelemente zur Verrastung bzw. Arretierung der Leiterplatte umfassen, sofern dies für eine zusätzliche mechanische Sicherung der Leiterplatte vorteilhaft ist.

Eine zweckmäßige Ausgestaltung der Erfindung ist dadurch gekennzeichnet, dass die Rastelemente eine der Leiterplatte zugewandte Seite und eine der Leiterplatte abgewandte Seite aufweisen, wobei der Rastbereich auf der der Leiterplatte zugewandten Seite und der Arretierbereich auf der der Leiterplatte abgewandten Seite ausgebildet ist. Die Leiterplatte ist zwischen den der Leiterplatte zugewandten Seiten der Rastelemente im Rastbereich anordenbar. Die Leiterplattenabdeckung ist ausgebildet, die Rastelemente auf der der Leiterplatte abgewandten Seite im Arretierbereich unter Bildung der Arretieranlage zu umgreifen. Die Rastelemente weisen vorzugsweise einen sich senkrecht von dem Gehäuseboden erstreckenden, Flachseiten aufweisenden Grundkörper auf. Dieser Grundkörper, mit der der Leiterplatte zugewandten Seite und der der Leiterplatte abgewandten Flachseite, ermöglicht eine zuverlässige zusätzliche mechanische Sicherung der Verbindung zwischen den Rastelementen, der Leiterplatte und der Leiterplattenabdeckung. Anders ausgedrückt sind die Rastelemente zweiseitig funktional ausgebildet, verfügen nämlich einerseits über eine Rastfunktion und andererseits über die Funktion einer zusätzlichen mechanischen Sicherung der einmal verrasteten Rastelemente mittels der Leiterplattenabdeckung. Dabei ist die der Leiterplatte abgewandte Flachseite des Rastelements vorteilhafterweise mit einer flach ausgestalteten Oberfläche versehen, um eine flächige Anlage zumindest eines Bereichs der Leiterplattenabdeckung zu gewährleisten, wodurch die Rastelemente mittels der Leiterplattenabdeckung zusätzlich von außen umgriffen werden. Auf diese Weise erfolgt eine einfach montierbare und demontierbare, jedoch zusätzlich mechanisch sichernde Anordnung der Leiterplatte. Zugleich bildet die Leiterplattenabdeckung einen Schutz der Leiterplatte vor direkter mechanischer Einwirkung, einen bedingten Schutz vor Spritzwasser und bildet zudem einen elektrisch isolierenden Berührschutz, der die elektronischen Bauelemente vor Zerstörung durch elektrostatische Aufladungen zuverlässig schützt.

Gemäß einer weiteren bevorzugten Ausführungsform der Erfindung umfasst der Gehäuseboden mindestens ein zumindest im Wesentlichen senkrecht zum Gehäuseboden verlaufend angeordnetes Positionierelement zur Positionierung der Leiterplatte, das zum formschlüssigen Eingriff in eine Positionierausnehmung der Leitplatte ausgebildet ist. Das Positionierelement ist vorzugsweise haltedornförmig ausgebildet. "Zumindest im Wesentlichen senkrecht" im Sinne der Erfindung heißt, entweder senkrecht zum Gehäuseboden oder nahezu senkrecht, d. h. mit einer Abweichung zur Senkrechten um maximal ± 10°. Das Vorhandensein des zumindest im Wesentlichen senkrecht zum Gehäuseboden verlaufend angeordneten Positionierelements bietet die Möglichkeit, dass die Leiterplatte einerseits zusätzlich stabilisiert wird, indem das Positionierelement vorzugsweise mittig von der Leiterplatte angeordnet ist, andererseits unterstützt das Positionierelement bei der Verrastung der Leiterplatte, indem die Leiterplatte bereits in der gewünschten Einbauhöhe sowie der Orientierung vorpositioniert wird und anschließend mittels der Rastelemente in der endgültigen Position verrastet. Das Positionierelement fungiert somit als Höhenanschlag für die Leiterplatte. In einer bevorzugten Ausführungsform ist das Positionierelement in Längsrichtung stufenweise ausgebildet, das heißt das Positionierelement weist unterschiedliche Durchmesser auf, die sich vorzugsweise in Richtung des Gehäusebodens vergrößern, abhängig von der Größe einer korrespondierenden Ausnehmung in der Leiterplatte, um dadurch die gewünschte Positionierposition auf der jeweiligen Stufe zu definieren. Es kann je nach Dimension der Leiterplatte sowie Anzahl, Baugröße und Masse der einzelnen elektronischen Bauelemente vorteilhaft sein, mehr als ein Positionierelement zur Positionierung der Leiterplatte senkrecht zum Gehäuseboden verlaufend anzuordnen. Weiterhin kann es vorteilhaft sein, dass das Positionierelement einen Hohlraum aufweist. Auf diese Weise wird bei möglichst geringem Materialverbrauch eine hohe Festigkeit des Rastelements erreicht.

Eine weitere zweckmäßige Ausgestaltung der Erfindung ist dadurch gekennzeichnet, dass das Gehäuseunterteil, insbesondere im Bereich des Gehäusebodens mit den Rastelementen, einstückig ausgebildet ist. Besonders vorteilhaft ist das gesamte Gehäuseunterteil einstückig ausgebildet. Eine einstückige Ausbildung des Gehäuseunterteils minimiert den Montageaufwand des Durchlauferhitzers, zudem weisen die einstückigen Elemente beispielsweise bessere Festigkeitseigenschaften auf, wodurch unter anderem die Dauerhaftigkeit des Durchlauferhitzers erhöht wird.

In einer weiteren vorteilhaften Ausführungsform der Erfindung umfassen die Rastelemente jeweils mindestens zwei der Rastbereiche, wobei die mindestens zwei Rastbereiche vom Gehäuseboden unterschiedlich weit beabstandet sind. Dies bietet den Vorteil, dass Leiterplatten ausgehend vom Gehäuseboden in unterschiedlichen Höhen in verschiedenen Rastpositionen verrastbar sind. Dadurch muss nur ein einziger Typ eines Gehäuseunterteils konstruiert und produziert werden, in den sich auf einfache Weise Leiterplatten in unterschiedlichen Höhen anordnen lassen, beispielsweise wenn diese elektronische Bauteile mit unterschiedlichen Dimensionen umfassen. Auf diese Weise reduzieren sich unter anderem die Kosten für Spritzgusswerkzeuge, da ein Gehäuseunterteil-Typ für eine Vielzahl von verschiedenen Durchlauferhitzer-Modellen einsetzbar ist.

Eine bevorzugte Weiterbildung der Erfindung zeichnet sich dadurch aus, dass mindestens zwei der Rastelemente an zwei Seiten der Leiterplatte angeordnet sind. Weiter bevorzugt sind mindestens zwei der Rastelemente an gegenüberliegenden Seiten der Leiterplatte angeordnet. Sofern die zwei Rastelemente an gegenüberliegenden Seiten der Leiterplatte angeordnet sind, erfolgt eine verbesserte Rastwirkung, indem die Leiterplatte zwischen den zwei Rastbereichen der Rastelemente angeordnet ist, da die Rastelemente an jeder der gegenüberliegenden Seiten der Leiterplatte als Federelement einander entgegenwirken. Die Leiterplatte ist somit formschlüssig und/oder kraftschlüssig zwischen den zwei einander federbelastend entgegenwirkenden Rastelementen verrastet. Weiter bevorzugt sind die mindestens zwei Rastelemente auf einer gedachten, die beiden Rastelemente miteinander verbindenden, Linie zumindest im Wesentlichen gegenüberliegend angeordnet. Auf diese Weise bilden die Rastelemente einander gegenüberliegende Lager für die Leiterplatte, so dass diese optimal zwischen den Rastelementen fixiert und gesichert ist.

Gemäß einer weiteren bevorzugten Ausführungsform weisen die Rastelemente ausgehend von dem Gehäuseboden einen sich in Vertikalrichtung verjüngenden Querschnitt auf. Durch den sich mit weiterem Abstand von dem Gehäuseboden verjüngenden Querschnitt der Rastelemente, wird die daran angeordnete Leiterplatte bezüglich ihres Abstands zu dem Gehäuseboden unterstützend in Position gehalten und mechanisch gesichert. Im oberen Bereich der Rastelemente wird auf diese Weise einerseits Material eingespart und so der Gesamtmaterialaufwand für die Rastelement minimiert und anderseits ausreichend Raum für die Anordnung der Leiterplatte sowie der Leiterplattenabdeckung bereitgestellt. Zudem wird auf diese Weise der Steifigkeit der Rastelemente in deren oberem Bereich definiert reduziert und so die gewünschte Federwirkung zur Umsetzung der gewünschten Rastfunktion der Rastelemente realisiert. Die zu dem Gehäuseboden hin anwachsende Materialstärke der Rastelemente sorgt für die erforderliche mechanische Stabilität der Rastelemente an deren Rastelementbasis, so dass diese gegen ein Abknicken vom Gehäuseboden gesichert sind.

Eine weitere zweckmäßige Ausgestaltung der Erfindung ist dadurch gekennzeichnet, dass mindestens eines der Rastelemente zumindest bereichsweise einen Hohlraumabschnitt aufweist. Der Hohlraumabschnitt unterstützt bei möglichst geringem Materialeinsatz die Steifigkeit der Rastelemente und wirkt damit insgesamt der Knickneigung des Rastelements entgegen. Vorzugsweise ist der Hohlraumabschnitt derart ausgestaltet, dass das Rastelement aus zwei einander gegenüberliegenden und parallel zueinander ausgerichteten Stegen gebildet ist. Weiter bevorzugt ist mindestens eine Seite des Hohlraumabschnitt offen ausgestaltet. Die vorgenannten Ausbildungen verringern die Gefahr des Knickens und erhöhen die Federsteifigkeit des Rastelements.

Eine zweckmäßige Ausgestaltung der Erfindung ist dadurch gekennzeichnet, dass die Leiterplattenabdeckung die Rastelemente mit der in der Rastposition befindlichen Leiterplatte lösbar arretiert. Ein lösbares Arretieren der Leiterplattenabdeckung ermöglicht einen einfachen Austausch oder eine Reparatur der Leiterplatte.

Gemäß einer weiteren bevorzugten Ausbildung der Erfindung umfasst die Leiterplattenabdeckung mindestens ein Halteelement zum lösbaren Verbinden der Leiterplatte und/oder mindestens eines der Rastelemente mit der Leiterplattenabdeckung. Somit wird eine Möglichkeit der lösbaren Anordnung der Leiterplattenabdeckung an der Leiterplatte und/oder an mindestens einem der Rastelemente zur Verfügung gestellt, wodurch beispielsweise Wartungs- und/oder Reparaturarbeiten an der Leiterplatte vorgenommen werden können bzw. ein Austausch von Leiterplatten mit geringem Aufwand erfolgen kann. Das Halteelement stellt eine lösbare mechanische Verbindung zwischen der Leiterplattenabdeckung und der Leiterplatte und/oder mindestens eines der Rastelemente her, vorzugsweise über eine Rastnase sowie eine Aufnahme für die Rastnase, wobei die Anordnung sowohl an der Leiterplatte als auch an der Leiterplattenabdeckung erfolgen kann. Besonders bevorzugt stellt das Halteelement eine schraubenlose mechanische Verbindung zwischen der Leiterplattenabdeckung und der Leiterplatte und/oder mindestens eines der Rastelemente her.

Eine bevorzugte Weiterbildung der Erfindung zeichnet sich dadurch aus, dass der Rastbereich der Rastelemente durch eine zumindest im Wesentlichen parallel zum Gehäuseboden verlaufende Einkerbung gebildet ist. "Zumindest im Wesentlichen parallel" im Sinne der Erfindung heißt, entweder parallel zum Gehäuseboden oder nahezu parallel, d. h. mit einer Abweichung zum Gehäuseboden um maximal ± 10°. Das Vorhandensein der zumindest im Wesentlichen parallel zum Gehäuseboden verlaufende Einkerbung bietet den Vorteil, dass die Leiterplatte einerseits in der Einkerbung sicher einrastbar ist, andererseits erfolgt die Ausrichtung in Verlauf des Gehäusebodens, was unter anderem den Einbau erleichtert. Die parallel zum Gehäuseboden verlaufende Einkerbung ist eine bewusst gewählte lokale Materialschwächung, die grundsätzlich je nach Anwendungszweck, das heißt je nach eingesetzter Leiterplatte, unterschiedliche Formen, Tiefen etc. aufweisen kann. Weiter bevorzugt ist die Einkerbung derart ausgebildet, dass die Leiterplatte zumindest bereichsweise in der Einkerbung kraftschlüssig anordenbar ist.

Eine weitere zweckmäßige Ausbildung der Erfindung ist dadurch gekennzeichnet, dass die Tiefe der Einkerbung zumindest im Wesentlichen der Dicke der Leiterplatte entspricht. Dies bietet den Vorteil, dass eine passgenau und vor einem Verrutschen gesicherte Verrastung der Leiterplatte in der Einkerbung erfolgt.

Gemäß einer weiteren bevorzugten Ausführungsform umfasst die Leiterplattenabdeckung einen umlaufenden Rand, der im Arretierzustand den Arretierbereich der Rastelemente unter Bildung der Arretieranlage umgreift. Der umlaufende Rand ist dabei vorzugsweise senkrecht zu der Leiterplattenabdeckung als flächiges Element ausgebildet. Der umlaufende Rand kann in einer vorteilhaften Gestaltung auch nur partiell um die Leiterplattenabdeckung ausgebildet sein. Der umlaufende Rand bietet auf einfache Art und Weise die Möglichkeit, durch eine möglichst einfache konstruktive Ausbildung ein Element zur Anlage an dem Arretierbereich bereitzustellen, was zuverlässig ein ungewolltes Lösen der verrasteten Leiterplatte verhindert.

Eine weitere zweckmäßige Ausgestaltung der Erfindung ist dadurch gekennzeichnet, dass die Leiterplattenabdeckung Durchgangsöffnungen umfasst, die im Arretierzustand den Arretierbereich der Rastelemente unter Bildung der Arretieranlage umgreifen. Mittels der Durchgangsöffnungen bieten die Rastelemente eine weitere einfache und sichere Lösung, um ein ungewolltes Lösen der verrasteten Leiterplatte zu verhindern, indem die Leiterplattenabdeckung formschlüssig mit den Rastelementen arretiert wird.

Weitere bevorzugte und/oder zweckmäßige Merkmale und Ausgestaltungen der Erfindung ergeben sich aus den Unteransprüchen und der Beschreibung. Besonders bevorzugte Ausführungsformen werden anhand der beigefügten Zeichnung näher erläutert. In der Zeichnung zeigt:
- Fig. 1: eine schematische Querschnittsansicht eines Gehäuseunterteils eines Durchlauferhitzers mit einer verrasteten Leiterplatte und einer Leiterplattenabdeckung
- und Fig. 2: eine schematische perspektivische Ansicht des Gehäuseunterteils des Durchlauferhitzers.

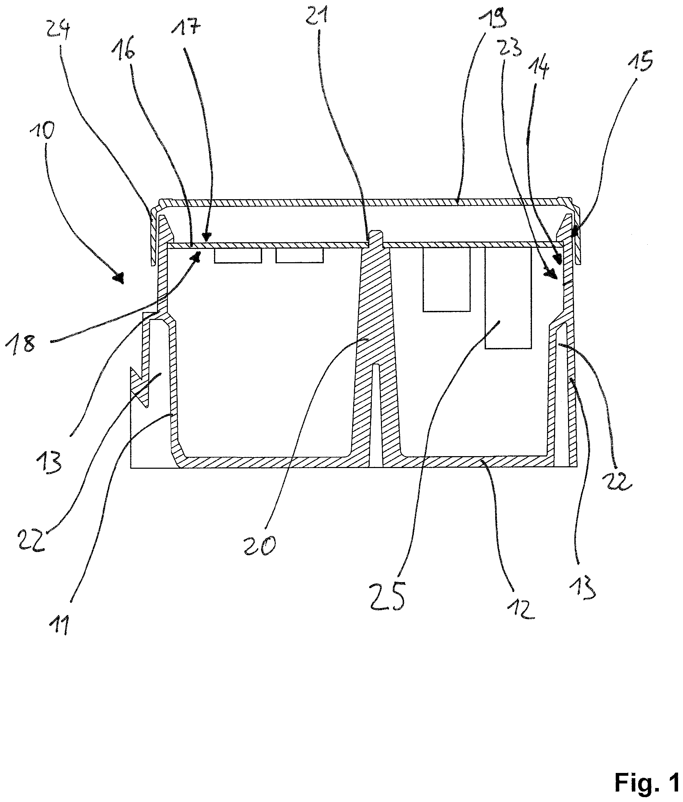

Fig. 1 zeigt eine schematische Querschnittsansicht eines Gehäuseunterteils 11 des - in den Zeichnungen nicht vollständig gezeigten - erfindungsgemäßen Gehäuses 10 eines Durchlauferhitzers. Das Gehäuseunterteil 11 umfasst einen Gehäuseboden 12 und mindestens zwei zumindest im Wesentlichen senkrecht zum Gehäuseboden 12 verlaufend angeordnete Rastelemente 13. Die Rastelemente 13 sind also zumindest im Wesentlichen orthogonal zu dem Gehäuseboden 12 angeordnet. Die Rastelemente 13 umfassen einen Rastbereich 14 und einen Arretierbereich 15 und sind zum lösbaren Anordnen an eine Leiterplatte 16 ausgebildet. Die Leiterplatte 16 umfasst eine Lötseite 17 und eine Bestückungsseite 18. In der Fig. 1 sind auf der Bestückungsseite 17 schematisch elektronische Bauteile 25 angeordnet, die unterschiedliche Bauhöhen aufweisen.

In der Fig. 1 ist beispielhaft gezeigt, wie die Leiterplatte 16 in dem Rastbereich 14 der Rastelemente 13 in einer Rastposition angeordnet ist. Die Rastelemente 13 weisen eine der Leiterplatte 16 zugewandte Seite und eine der Leiterplatte 16 abgewandte Seite auf. Der Rastbereich 14 ist auf der der Leiterplatte 16 zugewandten Seite und der Arretierbereich 15 auf der der Leiterplatte 16 abgewandten Seite ausgebildet. Zur Anordnung der Leiterplatte 16 in der Rastposition wird die Leiterplatte 16 in dem Rastbereich 14 positioniert. Der Rastbereich 14 erstreckt sich an den Rastelementen 13, die Rastfunktion wird hierbei von einer im Rastbereich 14 befindlichen Rastnase unterstützt, unter die die Leiterplatte 16 mit der Lötseite 17 anordenbar ist und auf diese Weise an dem Gehäuseunterteil 11 mechanisch sicher und gegen unerwünschtes Lösen fixiert ist.

Fig. 1 zeigt weiter eine Leiterplattenabdeckung 19, wobei die Leiterplattenabdeckung 19 die Lötseite 17 der Leiterplatte 16 zumindest bereichsweise abdeckt. Die Leiterplattenabdeckung 19 arretiert die Rastelemente 13 mit der in der Rastposition befindlichen Leiterplatte 16 in einem Arretierzustand. Die Leiterplattenabdeckung 19 ist zum Umgreifen der Rastelemente 13 im Arretierbereich 15 unter Bildung einer Arretieranlage ausgebildet. Die Arretieranlage erfolgt, indem die Leiterplattenabdeckung 19 im Arretierbereich 15 angeordnet ist. In der Fig. 1 ist sowohl der Bereich der Leiterplattenabdeckung 19, der an dem Arretierbereich 15 anliegt, als auch der eigentliche Arretierbereich 15 mit einer ebenen Oberfläche ausgebildet, was eine hohe Passgenauigkeit und eine präzise Arretierung der Rastelemente 13 ermöglicht.

Technisch bietet die Kombination aus Verrastung der Leiterplatte 16 und Arretierung der Rastelemente 13 eine Vielzahl an Vorteilen. Der Fig. 1 kann entnommen werden, dass die Leiterplatte 16 durch die Rastelemente 13 in Position gehalten wird, was diese gegen ein unerwünschtes Verschieben sichert. Aufgrund der geringen Auflagefläche, die der umlaufende Rand der Leiterplatte 16 bei dem Rastbereich 14 des Rastelements 13 bietet, ist die Leiterplatte 16 bei einer Bewegung eines der Rastelemente 13 gegen ein ungeplantes Lösen nur eingeschränkt gesichert. Sobald die Leiterplatte 16 aus einem Rastbereich 14 eines Rastelements 13 gelöst wird, bietet das weitere Rastelement 13 nicht mehr die erforderliche Stabilität, um die Leiterplatte 16 in Position zu halten. Durch die Leiterplattenabdeckung 19 wird einerseits die Leiterplatte 16 vor externen Faktoren wie zum Beispiel Spritzwasser zumindest bedingt geschützt, andererseits arretiert die Leiterplattenabdeckung 19 beide Rastelemente 13. Durch die Arretierung von beiden Rastelementen 13 werden mögliche auftretende Kräfte gegenüber einem Rastelement 13 verteilt und durch die Leiterplattenabdeckung 19 durch die flächige Arretieranlage aufgenommen. Ein Lösen der Leiterplatte 16 aus dem Rastbereich 14 der Rastelemente 13 wird auf diese Weise verhindert, da die umgreifende Leiterplattenabdeckung 19 die Funktion eines weiteren Sicherungselements übernimmt.

Vorteilhafterweise umfasst der Gehäuseboden 12 ein zumindest im Wesentlichen senkrecht zum Gehäuseboden 12 verlaufend angeordnetes Positionierelement 20 zur Positionierung der Leiterplatte 16, das zum formschlüssigen Eingriff in eine Positionierausnehmung 21 der Leitplatte 16 ausgebildet ist. Das Positionierelement 20 ist also zumindest im Wesentlichen orthogonal zu dem Gehäuseboden 12 angeordnet. Das Positionierelement 21 ist dabei besonders bevorzugt in der Mitte der Leiterplatte 16 angeordnet. Das Positionierelement 20 sowie die Positionierausnehmung 21 sind jedoch keine zwingenden Bestandteile, um ein zuverlässiges Verrasten und Arretieren der Leiterplatte 16 zu gewährleisten.

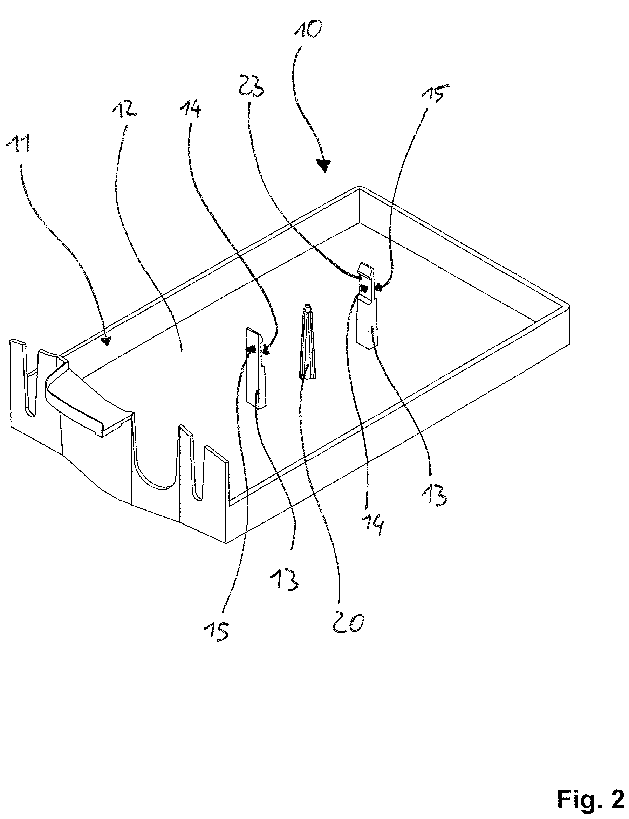

Fig. 2 zeigt eine schematische perspektivische Ansicht des Gehäuseunterteils 11 des Durchlauferhitzers ohne die mit der Leiterplattenabdeckung 19 verrastete und arretierte Leiterplatte 16. Aus Fig. 1 und 2 geht jedoch eindeutig die vorteilhafte Anordnung der Rastelemente 13 hervor. Die Rastelemente 13 sind hierzu an zwei Seiten der Leiterplatte 16 angeordnet. Wie aus Fig. 2 hervorgeht, sind die Rastelemente 13 besonders vorteilhaft gegenüberliegend angeordnet.

Die Rastelemente 13 sowie das Positionierelement 20 weisen vorzugsweise ausgehend von dem Gehäuseboden 12 einen sich in Vertikalrichtung verjüngenden Querschnitt auf. Der Querschnitt und/oder die Wandstärke der Elemente nimmt von dem Gehäuseboden 12 in Richtung der Öffnung des Gehäuseunterteils 11 ab.

Die Seitenansicht der Fig. 1 zeigt, dass die Rastelemente 13 zumindest bereichsweise einen Hohlraumabschnitt 22 aufweisen. Vorteilhafterweise weist auch das Positionierelement 20 einen Hohlraumabschnitt 22 auf. Der Hohlraumabschnitt 22 ist abhängig von der Größe der eingesetzten Rast- und Positionierelemente 13, 20 sowie der benötigten Steifigkeit.

Die Leiterplattenabdeckung 19 umfasst weiter bevorzugt mindestens ein - in den Zeichnungen nicht gezeigtes - Halteelement zum lösbaren Verbinden der Leiterplatte 16 und/oder mindestens eines der Rastelemente 13 mit der Leiterplattenabdeckung 19. Die Ausbildung des Halteelements erfolgt beispielsweise durch Haken, Rastmittel oder dergleichen.

Vorteilhafterweise ist der Rastbereich 14 der Rastelemente 13 durch eine zumindest im Wesentlichen parallel zum Gehäuseboden 12 verlaufende Einkerbung 23 gebildet. Die Einkerbung 23 kann dabei unterschiedliche Ausprägungen aufweisen. In Fig. 1 und Fig. 2 sind die Einkerbungen 23 als längliche Materialschwächung ausgebildet, in die die Leiterplatte 16 in der Rastposition angeordnet werden kann bzw. in die der Rand der Leiterplatte 16 rastend eingreift. Die Leiterplatte 16 wird dazu besonders vorteilhaft zumindest bereichsweise in der Einkerbung 23 kraftschlüssig angeordnet.

Wie in die Fig. 1 gezeigt, umfasst die Leiterplattenabdeckung 19 einen umlaufenden Rand 24, der im Arretierzustand den Arretierbereich 15 der Rastelemente 13 unter Bildung der Arretieranlage umgreift. Der umlaufende Rand 24 verläuft dazu vorzugsweise orthogonal zu der Leiterplattenabdeckung 19 und bildet mit dem Arretierbereich 15 eine formschlüssige Verbindung.

Weiter bevorzugt umfasst die Leiterplattenabdeckung 19 - in den Zeichnungen nicht gezeigte - Durchgangsöffnungen, die im Arretierzustand den Arretierbereich 15 der Rastelemente 13 unter Bildung der Arretieranlage umgreifen.

## Patentansprüche

1. Durchlauferhitzer, umfassend
ein Gehäuse (10) mit einem Gehäuseunterteil (11), wobei das Gehäuseunterteil (11) einen Gehäuseboden (12) umfasst,
**dadurch gekennzeichnet, dass**
der Gehäuseboden (12) mindestens zwei zumindest im Wesentlichen senkrecht zum Gehäuseboden (12) verlaufend angeordnete Rastelemente (13) mit einem Rastbereich (14) und einem Arretierbereich (15) umfasst,
wobei die Rastelemente (13) zum lösbaren Anordnen einer eine Lötseite (17) und eine Bestückungsseite (18) umfassenden Leiterplatte (16) ausgebildet sind, indem die Leiterplatte (16) zumindest im Rastbereich (14) der Rastelemente (13) in einer Rastposition anordenbar ist,
eine Leiterplattenabdeckung (19), wobei die Leiterplattenabdeckung (19) die Lötseite (17) der Leiterplatte (16) zumindest bereichsweise abdeckt und die Rastelemente (13) mit der in der Rastposition befindlichen Leiterplatte (16) in einem Arretierzustand arretiert, indem die Leiterplattenabdeckung (19) ausgebildet ist, die Rastelemente (13) im Arretierbereich (15) unter Bildung einer Arretieranlage zu umgreifen.

2. Durchlauferhitzer nach Anspruch 1, **dadurch gekennzeichnet, dass** die Rastelemente (13) eine der Leiterplatte (16) zugewandte Seite und eine der Leiterplatte (16) abgewandte Seite aufweisen, wobei der Rastbereich (14) auf der der Leiterplatte (16) zugewandten Seite und der Arretierbereich (15) auf der der Leiterplatte (16) abgewandten Seite ausgebildet ist, und wobei die Leiterplatte (16) zwischen den der Leiterplatte (16) zugewandten Seiten der Rastelemente (13) im Rastbereich (14) anordenbar ist und die Leiterplattenabdeckung (19) ausgebildet ist, die Rastelemente (13) auf den der Leiterplatte (16) abgewandten Seite im Arretierbereich (15) unter Bildung der Arretieranlage zu umgreifen.

3. Durchlauferhitzer nach Anspruch 1 oder 2, **dadurch gekennzeichnet, dass** der Gehäuseboden (12) mindestens ein zumindest im Wesentlichen senkrecht zum Gehäuseboden (12) verlaufend angeordnetes Positionierelement (20) zur Positionierung der Leiterplatte (16) umfasst, das zum formschlüssigen Eingriff in eine Positionierausnehmung (21) der Leitplatte (16) ausgebildet ist.

4. Durchlauferhitzer nach einem der Ansprüche 1 bis 3, **dadurch gekennzeichnet, dass** das Gehäuseunterteil (11), insbesondere im Bereich des Gehäusebodens (12) mit den Rastelementen (13), einstückig ausgebildet ist.

5. Durchlauferhitzer nach einem der Ansprüche 1 bis 4, **dadurch gekennzeichnet, dass** die Rastelemente (13) jeweils mindestens zwei der Rastbereiche (14) umfassen, wobei die mindestens zwei Rastbereiche (14) vom Gehäuseboden (12) unterschiedlich weit beabstandet sind.

6. Durchlauferhitzer nach einem der Ansprüche 1 bis 5, **dadurch gekennzeichnet, dass** mindestens zwei der Rastelemente (13) an zwei Seiten der Leiterplatte (16) angeordnet sind.

7. Durchlauferhitzer nach Anspruch 6, **dadurch gekennzeichnet, dass** mindestens zwei der Rastelemente (13) an gegenüberliegenden Seiten der Leiterplatte (16) angeordnet sind.

8. Durchlauferhitzer nach einem der Ansprüche 1 bis 7, **dadurch gekennzeichnet, dass** die Rastelemente (13) ausgehend von dem Gehäuseboden (12) einen sich in Vertikalrichtung verjüngenden Querschnitt aufweisen.

9. Durchlauferhitzer nach einem der Ansprüche 1 bis 8, **dadurch gekennzeichnet, dass** mindestens eines der Rastelemente (13) zumindest bereichsweise einen Hohlraumabschnitt (22) aufweist.

10. Durchlauferhitzer nach einem der Ansprüche 1 bis 9, **dadurch gekennzeichnet, dass** die Leiterplattenabdeckung (19) mindestens ein Halteelement zum lösbaren Verbinden der Leiterplatte (16) und/oder mindestens eines der Rastelemente (13) mit der Leiterplattenabdeckung (19) umfasst.

11. Durchlauferhitzer nach einem der Ansprüche 1 bis 10, **dadurch gekennzeichnet, dass** der Rastbereich (14) der Rastelemente (13) durch eine zumindest im Wesentlichen parallel zum Gehäuseboden (12) verlaufende Einkerbung (23) gebildet ist.

12. Durchlauferhitzer nach Anspruch 11, **dadurch gekennzeichnet, dass** die Einkerbung (23) derart ausgebildet ist, dass die Leiterplatte (16) zumindest bereichsweise in der Einkerbung (23) kraftschlüssig anordenbar ist.

13. Durchlauferhitzer nach einem der Ansprüche 11 oder 12, **dadurch gekennzeichnet, dass** die Tiefe der Einkerbung (23) zumindest im Wesentlichen der Dicke der Leiterplatte (16) entspricht.

14. Durchlauferhitzer nach einem der Ansprüche 1 bis 13, **dadurch gekennzeichnet, dass** die Leiterplattenabdeckung (19) einen umlaufenden Rand (24) umfasst, der im Arretierzustand den Arretierbereich (15) der Rastelemente (13) unter Bildung der Arretieranlage umgreift.

15. Durchlauferhitzer nach einem der Ansprüche 1 bis 14, **dadurch gekennzeichnet, dass** die Leiterplattenabdeckung (19) Durchgangsöffnungen umfasst, die im Arretierzustand den Arretierbereich (15) der Rastelemente (13) unter Bildung der Arretieranlage umgreifen.

## Claims

1. Continuous flow heater,
comprising a housing (10) with a bottom housing part (11), wherein the bottom housing part (11) comprises a housing base (12), **characterised in that** the housing base (12) comprises at least two latching elements (13) with a latching region (14) and a locking region (15) arranged at least substantially perpendicular to the housing base (12), wherein the latching elements (13) are configured for the releasable arrangement of a printed circuit board (16) comprising a solder side (17) and a component side (18), **in that** the printed circuit board (16) is arrangeable in a latching position at least in the latching region (14) of the latching elements (13), a printed circuit board cover (19), wherein the printed circuit board cover (19) covers the solder side (17) of the printed circuit board (16) at least in some areas and locks the latching elements (13) with the printed circuit board (16) in the latching position in a locking state, **in that** the printed circuit board cover (19) is configured to embrace the latching elements (13) in the latching area (15), forming a locking contact.

2. Continuous flow heater according to claim 1, **characterised in that** the latching elements (13) comprise a side directed towards the printed circuit board (16) and a side directed away from the printed circuit board (16), wherein the latching region (14) is configured on the side directed towards the printed circuit board (16) and the locking region (15) is configured on the side directed away from the printed circuit board (16), and wherein the printed circuit board (16) is arrangeable in the latching region (14) between the sides of the latching elements (13) directed towards the printed circuit board (16) and the printed circuit board cover (19) is configured to embrace the latching elements (13) on the side directed away from the printed circuit board (16) in the latching region (15), forming the locking contact.

3. Continuous flow heater according to claim 1 or 2, **characterised in that** the housing base (12) comprises at least one positioning element (20) arranged at least substantially perpendicularly to the housing base (12) for positioning the printed circuit board (16), which is configured for positive engagement in a positioning recess (21) of the printed circuit board (16).

4. Continuous flow heater according to one of claims 1 to 3, **characterised in that** the bottom housing part (11), in particular in the region of the housing base (12) with the latching elements (13), is configured in one piece.

5. Continuous flow heater according to one of claims 1 to 4, **characterised in that** the latching elements (13) each comprise at least two of the latching regions (14), wherein the at least two latching regions (14) are spaced at different distances from the housing base (12).

6. Continuous flow heater according to one of claims 1 to 5, **characterised in that** at least two of the latching elements (13) are arranged on two sides of the printed circuit board (16).

7. Continuous flow heater according to claim 6, **characterised in that** at least two of the latching elements (13) are arranged on opposite sides of the printed circuit board (16).

8. Continuous flow heater according to one of claims 1 to 7, **characterised in that** the latching elements (13) have a vertically tapering cross-section extending from the housing base (12).

9. Continuous flow heater according to one of claims 1 to 8, **characterised in that** at least one of the latching elements (13) comprises at least partially a cavity section (22).

10. Continuous flow heater according to one of claims 1 to 9, **characterised in that** the printed circuit board cover (19) comprises at least one retaining element for releasably connecting the printed circuit board (16) and/or at least one of the latching elements (13) to the printed circuit board cover (19).

11. Continuous flow heater according to one of claims 1 to 10, **characterised in that** the latching region (14) of the latching elements (13) is formed by a notch (23) extending at least substantially parallel to the housing base (12).

12. Continuous flow heater according to claim 11, **characterised in that** the notch (23) is configured in such a way that the printed circuit board (16) is at least partially arrangeable in the notch (23) in a force-locking manner.

13. Continuous flow heater according to one of claims 11 or 12, **characterised in that** the depth of the notch (23) corresponds at least substantially to the thickness of the printed circuit board (16).

14. Continuous flow heater according to one of claims 1 to 13, **characterised in that** the circuit board cover (19) comprises a circumferential edge (24) which, in the locking state, embraces the locking region (15) of the latching elements (13) to form the locking contact.

15. Continuous flow heater according to one of claims 1 to 14, **characterised in that** the printed circuit board cover (19) comprises through-openings which, in the locking state, embrace the locking region (15) of the latching elements (13) to form the locking contact.

## Revendications

1. Chauffe-eau instantané, comprenant
un boîtier (10) avec une partie inférieure de boîtier (11), la partie inférieure de boîtier (11) comprenant un fond de boîtier (12),
**caractérisé en ce que**
le fond de boîtier (12) comprend au moins deux éléments d'encliquetage (13) agencés au moins essentiellement perpendiculairement au fond de boîtier (12) avec une zone d'encliquetage (14) et une zone de blocage (15),
les éléments d'encliquetage (13) étant configurés pour agencer de manière amovible une carte de circuit imprimé (16) comprenant un côté de brasage (17) et un côté d'équipement (18), par le fait que la carte de circuit imprimé (16) peut être agencée dans une position d'encliquetage au moins dans la zone d'encliquetage (14) des éléments d'encliquetage (13),
un couvercle de carte de circuit imprimé (19), le couvercle de carte de circuit imprimé (19) recouvrant au moins par zones le côté de brasage (17) de la carte de circuit imprimé (16) et bloquant les éléments d'encliquetage (13) avec la carte de circuit imprimé (16) se trouvant dans la position d'encliquetage dans un état de blocage, par le fait que le couvercle de carte de circuit imprimé (19) est configuré pour entourer les éléments d'encliquetage (13) dans la zone de blocage (15) en formant un appui de blocage.

2. Chauffe-eau instantané selon la revendication 1, **caractérisé en ce que** les éléments d'encliquetage (13) présentent un côté tourné vers la carte de circuit imprimé (16) et un côté détourné de la carte de circuit imprimé (16), la zone d'encliquetage (14) étant configurée sur le côté tourné vers la carte de circuit imprimé (16) et la zone de blocage (15) sur le côté détourné de la carte de circuit imprimé (16), et la carte de circuit imprimé (16) pouvant être agencée entre les côtés des éléments d'encliquetage (13) tournés vers la carte de circuit imprimé (16) dans la zone d'encliquetage (14) et le couvercle de carte de circuit imprimé (19) étant configuré pour entourer les éléments d'encliquetage (13) sur le côté détourné de la carte de circuit imprimé (16) dans la zone de blocage (15) en formant l'appui de blocage.

3. Chauffe-eau instantané selon la revendication 1 ou 2, **caractérisé en ce que** le fond de boîtier (12) comprend au moins un élément de positionnement (20) pour le positionnement de la carte de circuit imprimé (16), agencé au moins essentiellement perpendiculairement au fond de boîtier (12), qui est configuré pour s'engager par complémentarité de forme dans un évidement de positionnement (21) de la carte de circuit imprimé (16).

4. Chauffe-eau instantané selon l'une quelconque des revendications 1 à 3, **caractérisé en ce que** la partie inférieure de boîtier (11) est configurée d'une seule pièce, notamment dans la zone du fond de boîtier (12) avec les éléments d'encliquetage (13).

5. Chauffe-eau instantané selon l'une quelconque des revendications 1 à 4, **caractérisé en ce que** les éléments d'encliquetage (13) comprennent chacun au moins deux des zones d'encliquetage (14), les au moins deux zones d'encliquetage (14) étant espacées du fond de boîtier (12) sur une distance différente.

6. Chauffe-eau instantané selon l'une quelconque des revendications 1 à 5, **caractérisé en ce qu'**au moins deux des éléments d'encliquetage (13) sont agencés sur deux côtés de la carte de circuit imprimé (16).

7. Chauffe-eau instantané selon la revendication 6, **caractérisé en ce qu'**au moins deux des éléments d'encliquetage (13) sont agencés sur des côtés opposés de la carte de circuit imprimé (16).

8. Chauffe-eau instantané selon l'une quelconque des revendications 1 à 7, **caractérisé en ce que** les éléments d'encliquetage (13) présentent une section transversale qui se rétrécit dans la direction verticale en partant du fond de boîtier (12).

9. Chauffe-eau instantané selon l'une quelconque des revendications 1 à 8, **caractérisé en ce qu'**au moins l'un des éléments d'encliquetage (13) présente au moins par zones une section de cavité (22).

10. Chauffe-eau instantané selon l'une quelconque des revendications 1 à 9, **caractérisé en ce que** le couvercle de carte de circuit imprimé (19) comprend au moins un élément de retenue pour relier de manière amovible la carte de circuit imprimé (16) et/ou au moins l'un des éléments d'encliquetage (13) au couvercle de carte de circuit imprimé (19).

11. Chauffe-eau instantané selon l'une quelconque des revendications 1 à 10, **caractérisé en ce que** la zone d'encliquetage (14) des éléments d'encliquetage (13) est formée par une encoche (23) s'étendant au moins essentiellement parallèlement au fond de boîtier (12).

12. Chauffe-eau instantané selon la revendication 11, **caractérisé en ce que** l'encoche (23) est configurée de telle sorte que la carte de circuit imprimé (16) peut être agencée au moins par zones dans l'encoche (23) par adhérence.

13. Chauffe-eau instantané selon l'une quelconque des revendications 11 ou 12, **caractérisé en ce que** la profondeur de l'encoche (23) correspond au moins essentiellement à l'épaisseur de la carte de circuit imprimé (16).

14. Chauffe-eau instantané selon l'une quelconque des revendications 1 à 13, **caractérisé en ce que** le couvercle de carte de circuit imprimé (19) comprend un bord périphérique (24) qui, à l'état de blocage, entoure la zone de blocage (15) des éléments d'encliquetage (13) en formant l'appui de blocage.

15. Chauffe-eau instantané selon l'une quelconque des revendications 1 à 14, **caractérisé en ce que** le couvercle de carte de circuit imprimé (19) comprend des ouvertures de passage qui, à l'état de blocage, entourent la zone de blocage (15) des éléments d'encliquetage (13) en formant l'appui de blocage.
